(19) Europäisches Patentamt / European Patent Office / Office européen des brevets

(11) **EP 2 657 818 A2**

(12) **EUROPEAN PATENT APPLICATION**

(43) Date of publication:
**30.10.2013 Bulletin 2013/44**

(51) Int Cl.:
***G06F 3/044*** *(2006.01)*

(21) Application number: **13164984.0**

(22) Date of filing: **23.04.2013**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **23.04.2012 KR 20120041883**

(71) Applicant: **Samsung Electronics Co., Ltd
Gyeonggi-do 443-742 (KR)**

(72) Inventor: **Kim, Hakyeol
443-742 Gyeonggi-do (KR)**

(74) Representative: **Birchenough, Lewis
Harrison Goddard Foote LLP
Saviour House
9 St Saviourgate
York YO1 8NQ (GB)**

(54) **Touch panel and method of manufacturing the same**

(57)    A touch panel using a conductive mesh and a method of manufacturing the same are provided. The touch panel includes a substrate on which a conductive mesh is disposed, a plurality of driving channels for recognizing a horizontal axis coordinate, wherein the plurality of driving channels are formed by patterning a first conductive mesh disposed on the substrate, a plurality of sensing channels for recognizing a vertical axis coordinate, wherein the sensing channels are formed by patterning a second conductive mesh disposed on the substrate, and an insulating layer positioned between the first conductive mesh and the second conductive mesh.

FIG. 3

EP 2 657 818 A2

**Description**

**BACKGROUND OF THE INVENTION**

1. Field of the Invention:

The present invention relates generally to a touch panel and a method of manufacturing the same. More particularly, although not exclusively, the present invention relates to a touch panel using a conductive mesh and a method of manufacturing the same.

2. Description of the Related Art:

Nowadays, due to a desire for greater convenience in inputting data into an apparatus, interest has increased in touch screen technology. A touch screen is typically formed by attaching a touch panel to a front surface of a display panel. Accordingly, the touch screen can perform both an input function and a display function. In particular, nowadays, interest has increased in technology for providing a multi- touch panel that can simultaneously recognize a plurality of touches occurring at different positions.

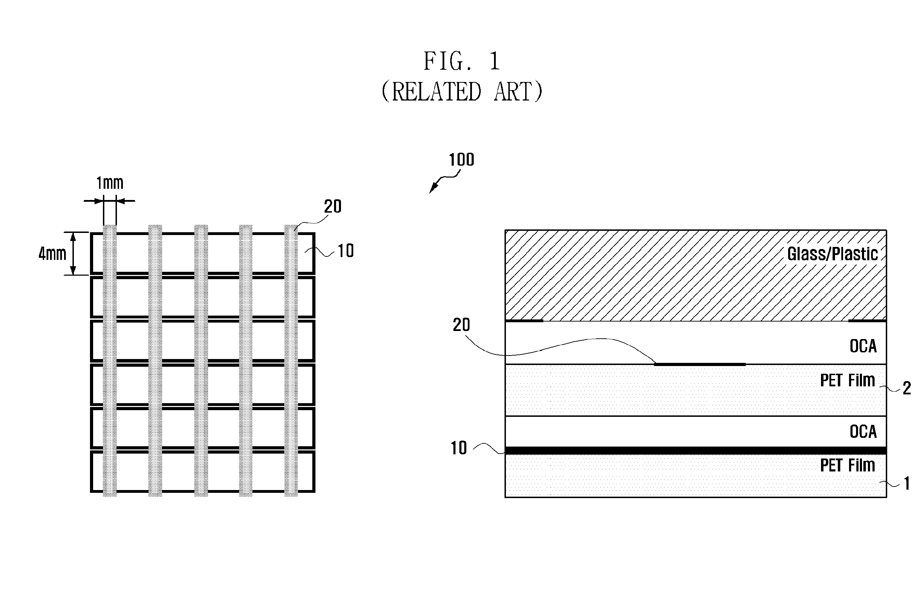

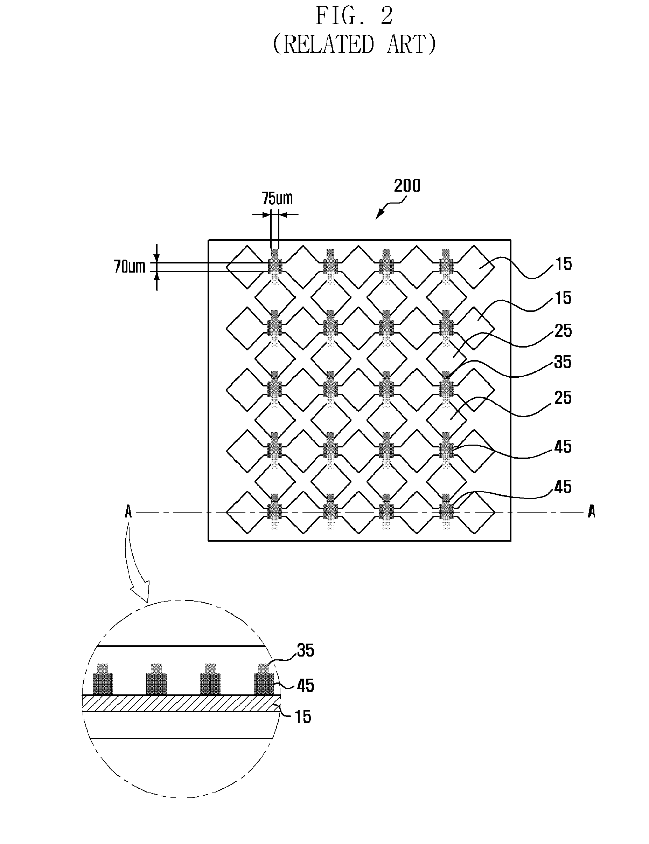

FIGs. 1 and 2 are diagrams illustrating a touch panel according to the related art.

Referring to FIG. 1, a touch panel 100 includes a plurality of driving channels 10 for recognizing a horizontal axis coordinate and a plurality of sensing channels 20 for recognizing a vertical axis coordinate. To prevent the driving channels 10 and the sensing channels 20 of the touch panel 100 from contacting each other, the driving channels 10 and the sensing channels 20 are stacked at different substrates 1 and 2 to have a predetermined separation distance. That is, the touch panel 100 has a 2-layer structure.

In such a touch panel 100, the driving channels 10 and the sensing channels 20 cross at a plurality of points, as shown in FIG. 1. For example, when the number of driving channels 10 is n (e.g. 6), and the number of sensing channels 20 is m (e.g. 5), the touch panel 100 has $n \times m$ (e.g. 6x5=30) crossing points. In this case, when it is assumed that a width of each driving channel 10 is $w_1$ (e.g. 4 mm) and a width of each sensing channel 20 is $w_2$ (e.g. 1mm), each crossing point of the touch panel 100 has an area of $w_1 \times w_2$ (e.g. $4 \times 1 = 4$ mm$^2$).

The touch panel 100 operates according to Equation 1.

$$\text{capacitance C} = (\text{dielectric constant} * \text{crossing area})/\text{separation distance}$$

$$\ldots \text{ Equation 1}$$

In Equation 1, C denotes the capacitance of the touch panel, "dielectric constant" denotes the permittivity of the dielectric layer(s) between the driving channels 10 and the sensing channels 20, "crossing area" denotes the total crossing areas of the crossing points, and "separation distance" denotes the separation distance between the driving channels 10 and the sensing channels 20.

From Equation 1, it can be seen that, in order to obtain the same performance (value C) when an area of each crossing point (crossing area of each crossing point) of the driving channels 10 and the sensing channels 20 increases, the touch panel 100 requires an increased separation distance. Further, as a dielectric constant of a layer between the driving channels 10 and the sensing channels 20 increases, the separation distance should be increased to achieve the same value of C. For example, when producing a first touch panel having the same performance as a second touch panel, in which the second touch panel includes driving channels 10 and sensing channels 20 formed at a separation distance of 0.2 mm using a PET film having a dielectric constant of 3.5, the first touch panel when using glass having a dielectric constant of 7 requires a separation distance of 0.4mm.

In general, in touch panels of the related art, exemplified by the touch panel 100 illustrated in FIG. 1, the driving channels 10 and the sensing channels 20 are typically formed using Indium Tin Oxide (ITO). However, when using ITO, a technical problem exists in attempting to reduce a crossing area of the driving channels 10 and the sensing channels 20. This is because when a width of the driving channels 10 and the sensing channels 20 is excessively reduced, the resistance of the driving channels 10 and the sensing channels 20 increases, and thus a touch signal cannot be smoothly transmitted. That is, as shown in FIG. 1, in the touch panel 100 having a 2-layer structure, it is difficult to reduce a thickness (separation distance) while maintaining a touch performance. In particular, when using a substrate having a relatively large dielectric constant, it is difficult to reduce a separation distance in the touch panel 100.

Another example of a touch panel 200 is shown in FIG. 2. The touch panel 200 has a 1-layer double pattern structure that forms a plurality of driving channel 15 and a plurality of sensing channel 25 on one substrate. In this case, the touch panel 200 has an insulating layer 45 at each crossing point of the driving channels 15 and the sensing channels 25. In this way, since the driving channels 15 and the sensing channels 25 are formed in one layer, the touch panel 200 has a structure with a relatively small separation distance. Therefore, to prevent a touch performance from deteriorating, a crossing area of the driving channels 15 and the sensing channels 25 should be minimized. Accordingly, a resistance value of the driving channels 15 and the sensing channels 25 should not be increased. To achieve this, in the touch panel 200, a width of a bridge 35 for connecting the sensing channels 25 and a width of a connecting portion of the driving channels 15 are made smaller than that of the sensing channel 25 and the driving channel 15, while a resistance value is prevented from increasing, a crossing area is reduced. That is, the touch panel 200 includes a structure in which a width of only a crossing portion of the driving channels 15 and the sensing channels 25 is reduced.

When it is assumed that a width of the bridge 35 of the touch panel 200 is 75 $\mu$m and a width of a connecting portion thereof is 70 $\mu$m (micrometers), each crossing point of the touch panel 200 has an area of 5250 $\mu$m$^2$ (=70*75) . That is, when the touch panel 200 of FIG. 2 has the same dielectric constant as the touch panel of FIG. 1, the touch panel 200 of FIG. 2 has a separation distance that is smaller than the separation distance of the touch panel of FIG. 1. Specifically the ratio of the separation distances of the touch panels of FIG. 2 and FIG. 1 is equal to 1/762 (=5250$\mu$m$^2$/ 4mm$^2$) . However, as shown in FIG. 2, when reducing a crossing area by reducing a width of the bridge 35 and a width of the connecting portion, the touch  panel 200 of FIG. 2 has a touch performance that is relatively low compared to the touch panel 100 of FIG. 1 due to a narrow width.

The above information is presented as background information only to assist with an understanding of the present disclosure. No determination has been made, and no assertion is made, as to whether any of the above might be applicable as prior art with regard to the present invention.

## SUMMARY OF THE INVENTION

It is an aim of certain embodiments of the present invention to address, solve, mitigate or obviate, at least partly, at least one of the problems and/or disadvantages of the related art, for example at least one of the above-mentioned problems and/or disadvantages. Certain embodiments of the present invention aim to provide at least one of the advantages described below.

Accordingly, certain embodiments of the present invention provide a touch panel and a method of manufacturing the same that can reduce a thickness of a touch panel without deterioration of a touch performance by forming a driving channel and a sensing channel with a conductive mesh (e.g., a metal mesh) and that can simplify a production process.

Certain embodiments of the present invention provide a touch panel and a method of manufacturing the same having a flexible property and capable of being formed in a large size.

In accordance with an aspect of the present invention, there is provided a touch panel comprising: one or more substrates; a plurality of first channels for recognizing a first axis coordinate; and a plurality of second channels for recognizing a second axis coordinate; wherein the first channels are formed from a first conductive mesh and the second channels are formed from a second conductive mesh.

In exemplary embodiments, the first channels are formed by patterning the first conductive mesh, and the second channels are formed by patterning the  second conductive mesh. In exemplary embodiments, the first conductive mesh and/or the second conductive mesh are printed on a substrate of the one or more substrates.

In exemplary embodiments, the first channels are formed by printing the first conductive mesh, and the second channels are formed by printing the second conductive mesh. In exemplary embodiments, the first conductive mesh and/or the second conductive mesh are disposed on a substrate of the one or more substrates.

In exemplary embodiments, an insulating layer is positioned between the first conductive mesh and the second conductive mesh, and the first conductive mesh is disposed on a first substrate.

In exemplary embodiments, the first conductive mesh is disposed on a first substrate, an insulating layer is disposed on the first conductive mesh, and the second conductive mesh is disposed on the insulating layer.

In exemplary embodiments, the first conductive mesh is disposed on a first surface of a first substrate, and the second conductive mesh is disposed on a second surface of the first substrate.

In exemplary embodiments, the first conductive mesh is disposed on a first substrate, the second conductive mesh is disposed on a second substrate, and the first and second substrates are adhered by an adhesive.

In exemplary embodiments, the first channels comprise driving channels and the second channels comprise sensing channels. In exemplary embodiments, the first axis coordinate is a horizontal axis coordinate, and the second axis coordinate is a vertical axis coordinate.

In accordance with an aspect of the present invention, a touch panel is provided. The touch panel includes a substrate in which a conductive mesh is disposed, a plurality of driving channels for recognizing a horizontal axis coordinate, wherein the plurality of driving channels are formed by patterning a first conductive mesh disposed at the substrate, a plurality of sensing channels for recognizing a vertical axis coordinate, wherein the plurality of sensing channels are formed by patterning a second conductive mesh disposed at the substrate, and an insulating layer positioned between the first conductive mesh and the second conductive mesh.

In accordance with another aspect of the present invention, a touch panel is provided. The touch panel includes a substrate in which a conductive mesh is disposed, a plurality of driving channels for recognizing a horizontal axis coordinate, wherein the plurality of driving channels are formed by patterning a first conductive mesh disposed on a first surface of the substrate, and a plurality of sensing channels for recognizing a vertical axis coordinate, wherein the plurality of sensing channels are formed by patterning a second conductive mesh disposed on a second surface, which is a surface opposite to the first surface of the substrate.

In accordance with another aspect of the present invention, a touch panel is provided. The touch panel includes a first substrate and a second substrate, a plurality of driving channels for recognizing a horizontal axis coordinate, wherein the plurality of driving channels are formed by patterning a first conductive mesh disposed on the first substrate, a plurality of sensing channels for recognizing a vertical axis coordinate, wherein the plurality of sensing channels are formed by patterning a second conductive mesh disposed on the second substrate, and a transparent adhesive for adhering the first substrate and the second substrate.

In accordance with another aspect of the present invention, a touch panel is provided. The touch panel includes a substrate, a plurality of driving channels for recognizing a horizontal axis coordinate, wherein the plurality of driving channels are formed by printing a first conductive mesh on the substrate, a plurality of sensing channels for recognizing a vertical axis coordinate, wherein the plurality of sensing channels are formed by printing a second conductive mesh on the substrate, and an insulating layer positioned between the first conductive mesh and the second conductive mesh.

In accordance with another aspect of the present invention, a method of manufacturing a touch panel is provided. The method includes coating a first conductive mesh on a substrate, patterning the first conductive mesh to correspond to a plurality of driving channels for recognizing a horizontal axis coordinate, coating an insulating layer on a substrate in which the plurality of driving channels are formed, coating a second conductive mesh on the substrate in which the insulating layer is coated, and patterning the second conductive mesh to correspond to a plurality of sensing channels for recognizing a vertical axis coordinate.

In accordance with another aspect of the present invention, a method of manufacturing a touch panel is provided. The method includes coating a first conductive mesh on a first surface of a substrate, patterning the first conductive mesh to correspond to a plurality of driving channels for recognizing a horizontal axis coordinate, coating a second conductive mesh on a second surface, which is a surface opposite to the first surface of the substrate, and patterning the second conductive mesh to correspond to a plurality of sensing channels for recognizing a vertical axis coordinate.

In accordance with another aspect of the present invention, a method of manufacturing a touch panel is provided. The method includes coating a first conductive mesh on a first substrate, patterning the first conductive mesh to correspond to a plurality of driving channels for recognizing a horizontal axis coordinate, coating a second conductive mesh on a second substrate, patterning the second conductive mesh to correspond to a plurality of sensing channels for recognizing a vertical axis coordinate, and adhering the patterned first and second substrates.

In accordance with another aspect of the present invention, a method of manufacturing a touch panel is provided. The method includes printing a first conductive mesh to correspond to a plurality of driving channels for recognizing a horizontal axis coordinate in a substrate, printing an insulating layer in a substrate in which the plurality of driving channels are printed, and printing a second conductive mesh to correspond to a plurality of sensing channels for recognizing a vertical axis coordinate in the substrate in which the insulating layer is printed.

As described above, in a touch panel and a method of manufacturing the same according to certain exemplary embodiments of the present invention, by forming a driving channel and a sensing channel using a conductive mesh, a thickness of a touch panel can be reduced without deterioration of a touch performance.

Further, in certain exemplary embodiments, by forming a driving channel and a sensing channel using the conductive mesh, lower resistance than that of a related- art transparent electrode (e.g., ITO) can be obtained. Thereby, according to certain exemplary embodiments of the present invention, a touch performance of a touch panel can be improved, and a relatively large- sized touch panel can be produced.

Further, in certain exemplary embodiments, by simplifying a production process, a production cost of a touch panel can be reduced.

Further, in certain exemplary embodiments, as a conductive mesh is used, even if a touch panel is bent, a crack does not occur in a driving channel and a sensing channel and thus a flexible touch panel can be produced.

Other aspects, advantages, and salient features of the invention will become apparent to those skilled in the art from the following detailed description, which, taken in conjunction with the annexed drawings, discloses exemplary embodiments of the invention.

## BRIEF DESCRIPTION OF THE DRAWINGS

The above and other aspects, and features and advantages of certain exemplary embodiments of the present invention will be more apparent from the following description taken in conjunction with the accompanying drawings, in which:

FIGs. 1 and 2 are diagrams illustrating touch panels according to the related art;

FIG. 3 is a flowchart illustrating a process of manufacturing a touch panel according to an exemplary embodiment of the present invention;

FIGs. 4A and 4B are diagrams illustrating a process of manufacturing a touch panel according to a first exemplary embodiment of the present invention;

FIGs. 5A and 5B are diagrams illustrating a process of manufacturing a touch panel according to a second exemplary embodiment of the present invention;

FIG. 6 is a diagram illustrating a process of manufacturing a touch panel according to a third exemplary embodiment of the present invention; and

FIG. 7 is a diagram illustrating a process of manufacturing a touch panel according to a fourth exemplary embodiment of the present invention.

Throughout the drawings, it should be noted that the same or similar reference numbers may be used to depict the same or similar elements, features, and/or structures although they may be illustrated in different drawings.

## DETAILED DESCRIPTION OF EXEMPLARY EMBODIMENTS

The following description with reference to the accompanying drawings is provided to assist in a comprehensive understanding of exemplary embodiments of the invention as defined by the claims. It includes various specific details to assist in that understanding but these are to be regarded as merely exemplary. Accordingly, those of ordinary skill in the art will recognize that various changes and modifications of the embodiments described herein can be made without departing from the scope of the invention.

Detailed descriptions of well-known functions, processes, structures and/or constructions may be omitted for clarity and conciseness, and to avoid obscuring the subject matter of the present invention.

The terms and words used in the following description and claims are not limited to the bibliographical meanings, but, are merely used to enable a clear and consistent understanding of the invention. Accordingly, it should be apparent to those skilled in the art that the following description of exemplary embodiments of the present invention is provided for illustration purpose only and not for the purpose of limiting the invention as defined by the appended claims.

Throughout the description and claims of this specification, the words "comprise" and "contain" and variations of the words, for example "comprising" and "comprises", means "including but not limited to", and is not intended to (and does not) exclude other moieties, additives, components, integers or steps.

Throughout the description and claims of this specification, the singular encompasses the plural unless the context otherwise requires. In particular, it is to be understood that the singular forms "a," "an," and "the" include plural referents unless the context clearly dictates otherwise. Thus, for example, reference to "a component surface" includes reference to one or more of such surfaces.

Features, integers, characteristics, compounds, chemical moieties or groups described in conjunction with a particular aspect, embodiment or example of the invention are to be understood to be applicable to any other aspect, embodiment or example described herein unless incompatible therewith.

It will be also be appreciated that, throughout the description and claims of this specification, language in the general form of "X for Y" (where Y is some action, activity or step and X is some means for carrying out that action, activity or step) encompasses means X adapted, configured or arranged specifically, but not exclusively, to do Y.

While the present invention may be embodied in many different forms, specific exemplary embodiments of the present invention are shown in drawings and are described herein in detail, with the understanding that the present disclosure is to be considered as an exemplification of the principles of the invention and is not intended to limit the invention to the specific exemplary embodiments illustrated.

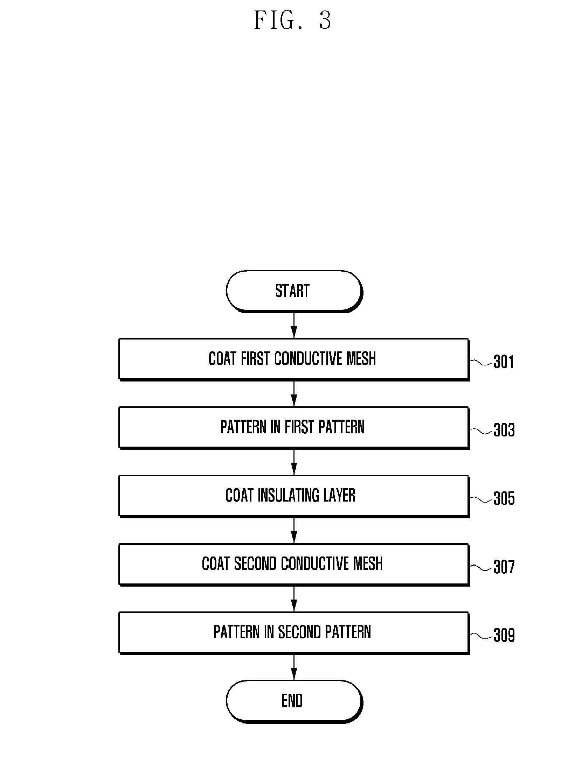

FIG. 3 is a flowchart illustrating a process of manufacturing a touch panel according to an exemplary embodiment of the present invention.

Referring to FIG. 3, in a process of manufacturing a touch panel according to the present exemplary embodiment, a first conductive mesh is coated or laid on a substrate in step 301. The first conductive mesh is made of a metal material, for example copper, silver, and aluminum. In this case, the first conductive mesh may have a line width of several $\mu$m (e.g., 1-10 $\mu$m, for example 5 $\mu$m, or any other suitable line width). Further, by applying darkening technology and/or a mesh chemical processing to the conductive mesh, performance deterioration according to a change of temperature and/or humidity is minimized.

The substrate is a constituent element forming a base on which can be coated or formed a sensing channel and a driving channel formed using a conductive mesh. When a touch panel is used as part of a touch screen, the substrate may be a transparent substrate, and when the touch panel is used as part of a touch pad, the substrate may be an opaque substrate. When the touch panel is applied to a flexible touch screen, the substrate is made of a flexible material. Further, the substrate may be changed according to a production method of the touch panel. For example, the substrate may be formed with a protection window, display panel, polarizer, and/or Polyethylene Terephthalate (PET) film. This will be described in detail later.

Next, the first conductive mesh is patterned in a first pattern in step 303. For example, a first conductive mesh coated on the substrate may be patterned in a first pattern, for example using a photo process (e.g. laser patterning or photo etching or lithography) . In this case, the first pattern may be a pattern corresponding to (e.g. forming) a plurality of driving channels for recognizing a horizontal axis coordinate.

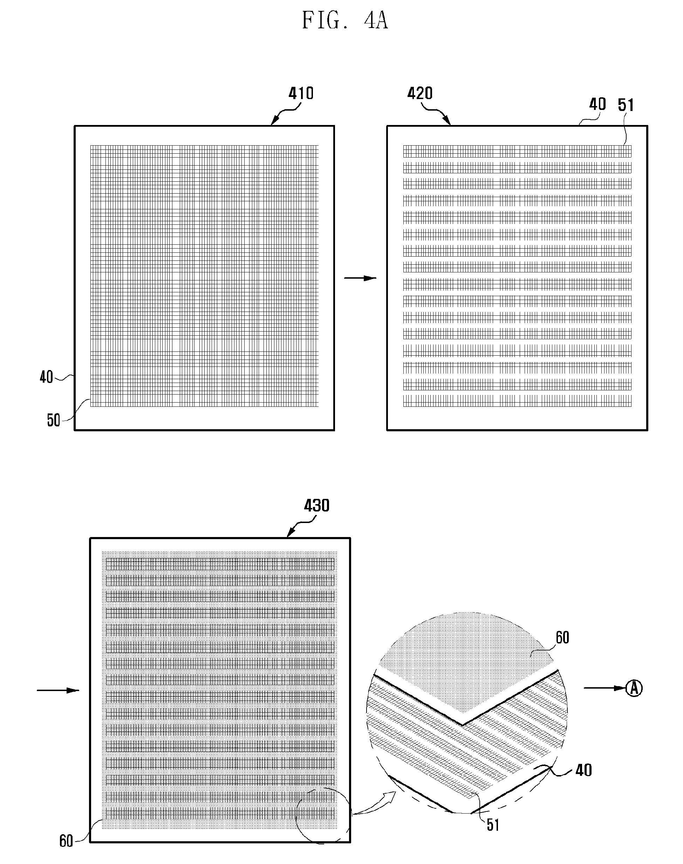

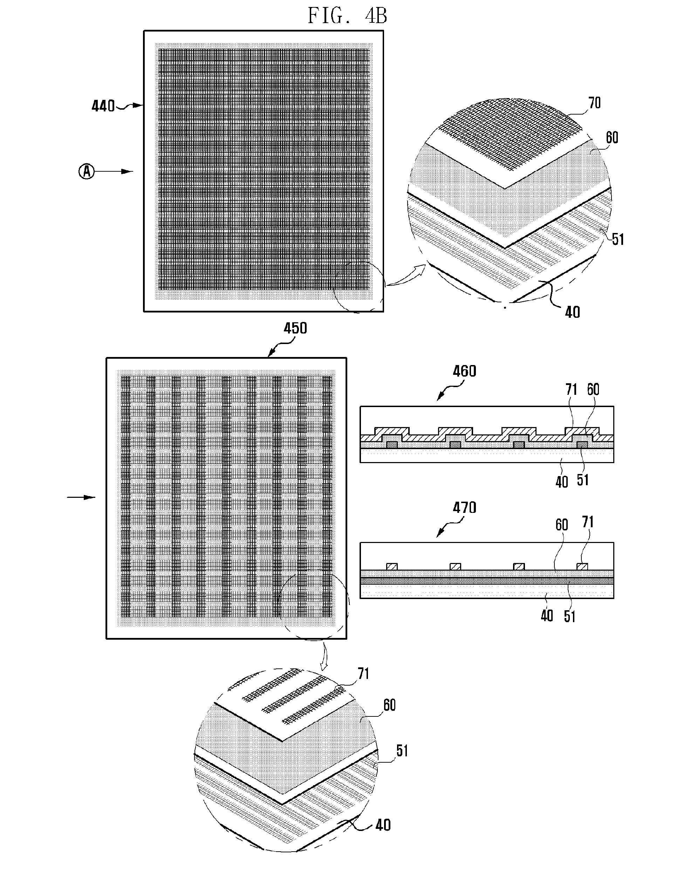

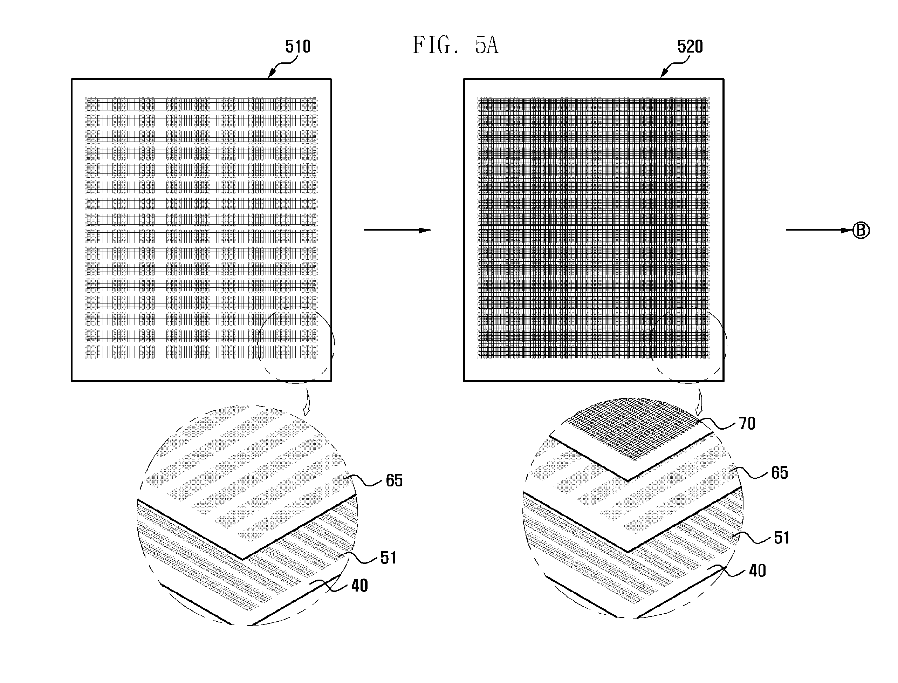

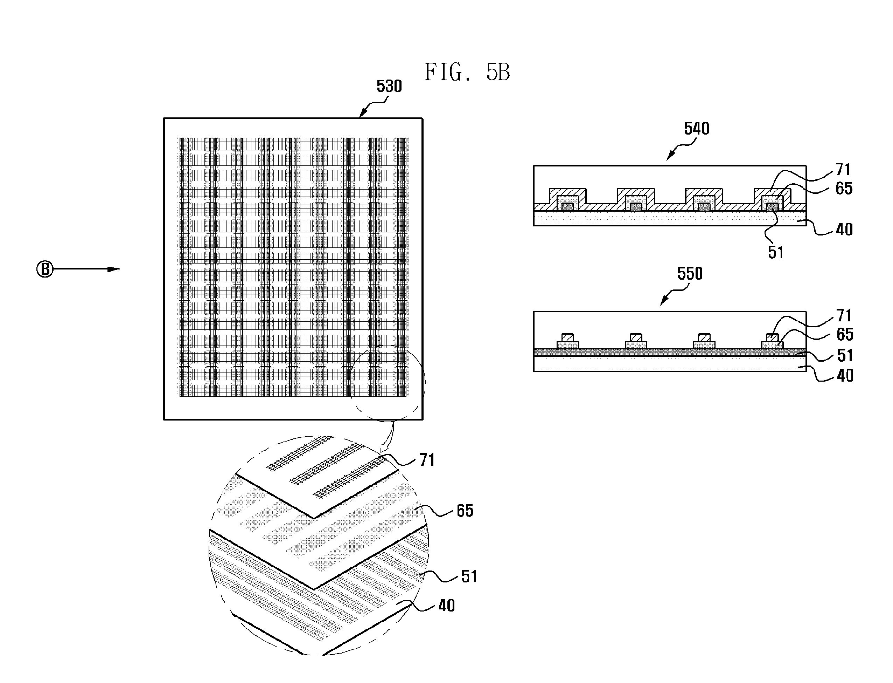

When patterning of the first conductive mesh is complete, an insulating layer is coated, laid or formed on the patterned first conductive mesh layer in step 305. In this case, the insulating layer may be coated on an entire area in which the first conductive mesh is coated (see FIGs. 4A and 4B to be described later) or, alternatively, only at an area in which the driving channels and a plurality of sensing channels formed using a second conductive mesh overlap (see FIGs. 5A and 5B to be described later).

When coating, laying or forming of the insulating layer on the patterned first conductive mesh layer is complete, a second conductive mesh is coated, laid or formed on the insulating layer in step 307. The second conductive mesh may have the same configuration as that of the first conductive mesh, as described above. When coating, laying or forming of the second conductive mesh on the insulating layer is complete, the second conductive mesh is patterned in a second pattern in step 309. The second pattern may be a pattern corresponding to (e.g. forming) a plurality of sensing channels for recognizing a vertical axis coordinate.

In certain embodiments, steps 301 and 303 may be performed with one process. For example, a conductive mesh may be printed to have a first pattern on the substrate. Similarly, in certain embodiments, steps 307 and 309 may be performed with one process. In certain embodiments, the insulating layer may be also stacked on the substrate using a printing method.

Further, although not shown in FIG. 3, in order to protect the second pattern, a process of manufacturing a touch panel according to the present exemplary embodiment may further include the optional step of printing, coating, laying or forming a protective layer, or stacking a protection substrate, for example on the patterned second conductive mesh layer.

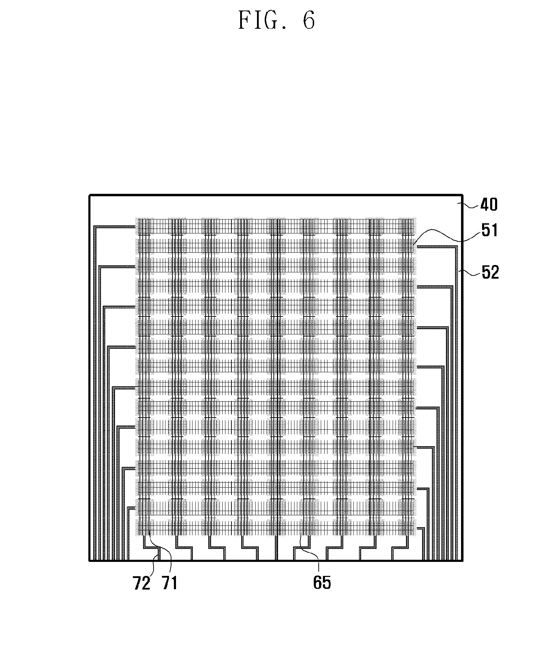

Further, the first pattern may include (e.g. form) a plurality of first wirings connected to a plurality of driving channels, respectively, and for transmitting a touch signal sensed by a driving channel to a touch processor (e.g., a touch driver Integrated Circuit, IC) . In certain exemplary embodiments of the present invention, when patterning the first conductive mesh, a driving channel and a first wiring connected to the driving channel may be simultaneously patterned. Similarly, the second pattern may be connected to a plurality of sensing channels, and a plurality of second wirings for transmitting a touch signal sensed by the sensing channel to a touch processor may be included. In certain exemplary embodiments of the present invention, when patterning a second conductive mesh, a sensing channel and a second wiring connected to the sensing channel may be simultaneously patterned. A detailed description thereof will be described later with reference to FIG. 6.

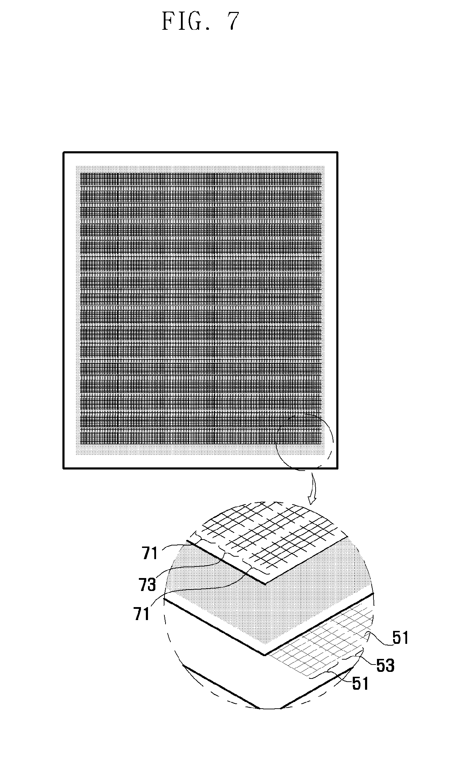

Further, in the foregoing description, it was described that patterning is performed to correspond to driving channels and sensing channels, but embodiments of the present invention are not limited thereto. For example, in other exemplary embodiments of the present invention, an entire conductive mesh positioned between a driving channel and a sensing channel is not removed and only a partial conductive mesh may be removed. This is to improve visibility. A detailed description thereof will be described later with reference to FIG. 7.

Further, in the foregoing description, it was described that driving channels and sensing channels are coated or formed on the same surface (e.g. the same side) of the substrate, but embodiments of the present invention are not limited thereto. For example, the sensing channels may be coated or formed on one surface (e.g., a front surface) of the substrate, and the driving channels may be coated or formed on an opposite surface (e.g., a rear surface) of the substrate.

Further, in the foregoing description, it was described that driving channels and sensing channels are coated or formed on one substrate, but embodiments of the present invention are not limited thereto. For example, in other embodiments of the present invention, the driving channels and the sensing channels may each be formed in or on different substrates. For example, in the present exemplary embodiment, after the sensing channels are coated or formed on a first substrate and the driving channels are coated or formed on a second substrate, the first substrate and the second substrate may be adhered using a transparent adhesive.

FIGs. 4A and 4B are diagrams illustrating a process of manufacturing a touch panel according to a first exemplary embodiment of the present invention.

Referring to FIGs. 4A and 4B, in a method of manufacturing a touch panel according to the first exemplary embodiment of the present invention, as denoted in the drawing by reference numeral 410, a first conductive mesh 50 is coated on a substrate 40. The substrate 40 may include a touch area in which a plurality of driving channels and a plurality of sensing channels for sensing a touch are formed, and a wiring area in which wirings for transmitting a touch signal sensed through the driving channels and the sensing channels to a touch processor (e.g., a touch driver IC) are formed. In this case, the first conductive mesh 50 may be coated on a touch area or an entire area of the substrate 40.

The substrate 40 may be, for example, a display panel including various elements, for example: a protection window; a display, for example in the form of a Liquid Crystal Display (LCD), or Organic Light Emitting Diode (OLED); a polarizer or a PET film made of a glass; and Poly Carbonate (PC) or Poly Methyl Methacrylate (PMMA) material, and the like, that may coat a conductive mesh. FIGs. 4A and 4B illustrate the first conductive mesh 50 having a rectangular structure, however embodiments of the present invention are not limited thereto. For example, the first conductive mesh 50 may have a structure in the form of a lozenge, hive, and/or nano wire. The first conductive mesh 50 may be made of any suitable conductive material, for example a metal material, for example copper, silver, and aluminum. In this case, it is advantageous, but not necessary, that the first conductive mesh 50 has a relatively small line width, for example several $\mu$m (e.g., 1-10$\mu$m, for example 5 $\mu$m) and the first conductive mesh 50 is formed so as to be not visible by a user, for example using darkening technology and/or a mesh chemical processing, and such that performance deterioration according to a change of temperature and/or humidity is minimized. Unlike a related-art ITO, even if the conductive mesh is bent, a crack does not occur. Therefore, a touch panel of the present exemplary embodiment may be formed to have a flexible property.

Next, as indicated by reference numeral 420, the first conductive mesh 50 is patterned to have (e.g. to form) a first pattern corresponding to (e.g. forming) a plurality of driving channels 51 for recognizing a horizontal axis coordinate. For example, the first conductive mesh 50 may be patterned to have a first pattern through any suitable technique, for example a photo process.

When patterning of the first conductive mesh 50 is complete, as indicated by reference numeral 430, an insulating layer 60 is coated, laid or formed on the patterned first conductive mesh layer. In this case, the insulating layer 60 is coated to cover the entire plurality of driving channels 51. In the enlarged view shown in FIG. 4A of the structure denoted by reference numeral 430, the first conductive mesh 50 and the insulating layer 60 are shown as separated. However, this illustration is for convenience of description; the first conductive mesh 50 and the insulating layer 60 are actually sequentially stacked on the substrate 40, for example without separation.

When coating of the insulating layer 60 on the patterned first conductive mesh layer is complete, as indicated by reference numeral 440, a second conductive mesh 70 is coated, laid or formed on the insulating layer 60 in a touch area or an entire area of the substrate 40. In the enlarged view shown in FIG. 4B of the structure denoted by reference numeral 440, the plurality of driving channels 51, the insulating layer 60, and the second conductive mesh 70 are shown as separated. However, this illustration is for convenience of description; the plurality of driving channels 51, the insulating layer 60, and the second conductive mesh 70 are actually sequentially stacked on the substrate 40, for example without separation.

When coating of the second conductive mesh 70 on the insulating layer 60 is complete, as indicated by reference numeral 450, the second conductive mesh 70 is pattered to have (e.g. form) a second pattern corresponding to (e.g. forming) a plurality of sensing channels for recognizing a vertical axis coordinate. In the enlarged view shown in FIG. 4B of the structure denoted by reference numeral 450, a plurality of driving channels 51, an insulating layer 60, and a plurality of sensing channels 71 are shown as separated. However, as shown in the cross-sectional views of FIG. 4B denoted by reference numeral 460 and reference numeral 470, the plurality of driving channels 51, the insulating layer 60, and the plurality of sensing channels 71 are actually sequentially stacked on the substrate 40, for example without separation. In this case, the drawing denoted by the reference numeral 460 is a cross-sectional view of the touch panel taken in a vertical direction, and the drawing denoted by reference numeral 470 is a cross-sectional view of the touch panel taken in a horizontal direction. That is, a touch panel according to the first exemplary embodiment of the present invention includes: the substrate 40 on which is coated a conductive mesh; the first conductive mesh 50 coated on the substrate and patterned to have a first pattern corresponding to the driving channel 51; an insulating layer 60 coated on the first conductive mesh 50; the second conductive mesh 70 coated on the insulating layer 60 and patterned to have a second pattern corresponding to the sensing channel 71; wherein the insulating layer 60 is positioned between the first conductive mesh 50 and the second conductive mesh 70.

As shown in the drawing of the reference numeral 450, the driving channels 51 and the sensing channels 71 include a plurality of mesh lines and cross at a plurality of points. In this case, when it is assumed that the number of mesh lines of each driving channel 51 is 20, the number of mesh lines of each sensing channel 71 is 10, and a line width of each mesh line is 5 $\mu$m, then an area of each crossing point is equal to 5000 $\mu$m$^2$ = (20*5) * (10*5) . In this case, it can be seen that an area of each crossing point of a touch panel of the present exemplary embodiment has a value similar to a crossing area of each crossing point (5250 $\mu$m2) of the related- art touch panel 200 having the 1- layer double pattern structure of FIG. 2. Therefore, in the present exemplary embodiment, a touch panel may be produced in which the driving channels 51 and the sensing channels 71 have a separation distance of tens of nm (nanometers) to several $\mu$m (e.g. 10 nm- 10 $\mu$m) . In particular, in the present exemplary embodiment, instead of forming the driving channels 51 and the sensing channels 71 using ITO having relatively large resistivity (intrinsic resistance) as in typical related- art touch panels, by forming the driving channels 51 and the sensing channels 71 with a conductive mesh of a conductive material (e.g. metal material) having relatively small resistivity, a separation distance can be significantly reduced, for example compared to the touch panel of FIG. 1, and only a width of a crossing point may not be reduced, for example like the related- art touch panel 200 of FIG. 2.

FIGs. 5A and 5B are diagrams illustrating a process of manufacturing a touch panel according to a second exemplary embodiment of the present invention.

Referring to FIGs. 5A and 5B, in a process of providing a touch panel according to the second exemplary embodiment of the present invention, a first conductive mesh is coated, laid or formed on a touch area or an entire area of a substrate 40, and the first conductive mesh is patterned according to a first pattern to form a plurality of driving channels for recognizing a horizontal axis coordinate. That is, in a process of providing a touch panel according to the second exemplary embodiment of the present invention, a plurality of driving channels 51 are formed through the same process as processes 410 and 420 of FIG. 4.

Next, as indicated by reference numeral 510, an insulating layer 65 is coated, laid or formed. In this case, in order to prevent the driving channels 51 and the sensing channels 71 from electrically contacting, the insulating layer 65 is coated, laid or form only at a crossing area of the driving channels 51 and the sensing channels 71. When coating, laying or forming of the insulating layer 65 is complete, in the present exemplary embodiment, as indicated by reference numeral 520, a second conductive mesh 70 is coated, laid or formed on the insulating layer 65. In the enlarged view shown in FIG. 5A of the structure denoted by reference numeral 520, the plurality of driving channels 51, the insulating layer 65, and the second conductive mesh 70 are shown as separated. However, these components are actually sequentially stacked on the substrate 40, for example without separation.

When coating of the second conductive mesh 70 on the insulating layer 65 is complete, in the present exemplary embodiment, as indicated by reference numeral 530, the second conductive mesh 70 is pattered according to a second pattern to form a plurality of sensing channels for recognizing a vertical axis coordinate. In the enlarged view shown in FIG. 5B of the structure denoted by reference numeral 530, the plurality of driving channels 51, the insulating layer 65, and the plurality of sensing channels 71 are shown as separated. However, as shown in the cross-sectional views of FIG. 5B denoted by reference numerals 540 and 550, the plurality of driving channels 51, the insulating layer 65, and the plurality of sensing channels 71 are actually sequentially stacked on the substrate 40, without separation. Here, the drawing denoted by the reference numeral 540 is a cross-sectional view of a touch panel taken in a vertical direction, and the drawing denoted by reference numeral 550 is a cross-sectional view of a touch panel taken in a horizontal direction. A process of manufacturing a touch panel according to the second exemplary embodiment of the present invention is the same as that of the first exemplary embodiment described with reference to FIGs. 4A and 4B, except for a difference in which an insulating layer is coated only at an area in which the driving channels and the sensing channels overlap.

FIG. 6 is a diagram illustrating a process of manufacturing a touch panel according to a third exemplary embodiment of the present invention.

Referring to FIG. 6, in a third exemplary embodiment of the present invention, a wiring for transmitting a touch signal sensed through a driving channel and a sensing channel to a touch processor is patterned together with (e.g. at the same time as) patterning of a first conductive mesh 50 and a second conductive mesh 70. That is, in the related art, a process of forming a wiring is typically performed separately from a process of forming driving channels and sensing channels. However, in the third exemplary embodiment of the present invention, after the first conductive mesh 50 is coated on an entire wiring area and a touch area of a substrate 40, in a patterning process of the first conductive mesh 50, the first conductive mesh 50 may be patterned to have (e.g. form) a pattern corresponding to (e.g. forming) a plurality of driving channels 51 and a plurality of first wirings 52 for transmitting a touch signal of the driving channels 51 to a touch processor (touch driver IC). Similarly, after coating the second conductive mesh 70 on an entire wiring area and a touch area of the substrate 40, in a patterning process of the second conductive mesh 70, the second conductive mesh 70 may be patterned to have (e.g. form) a pattern corresponding to (e.g. forming) a plurality of sensing channels 71 and a plurality of second wirings 72 for transmitting a touch signal of the sensing channels 71 to a touch processor (touch driver IC).

In this case, a line width of a conductive mesh forming the driving channel 51 and the sensing channel 71 and a line width of a conductive mesh forming the first wiring 52 and the second wiring 72 may be different. For example, because the first wiring 52 and the second wiring 72 are positioned at an area not exposed to a user, it may be unnecessary to form a mesh having a relatively thin line width. Therefore, a line width (e.g., 100 $\mu$m) of the first wiring 52 and the second wiring 72 may be formed larger than a line width (e.g., 5 $\mu$m) of the driving channel 51 and the sensing channel 71. This is to make a resistance value of the first wiring 52 and the second wiring 72 low.

Here, in an entire production process of a touch panel according to the third exemplary embodiment of the present invention, the first conductive mesh 50 is coated, laid or formed on a touch area and a wiring area of the substrate 40. When coating of the first conductive mesh 50 on the substrate 40 is complete, the first conductive mesh 50 is patterned to have (e.g. form) a pattern corresponding to (e.g. forming) the driving channels 51 and the first wiring 52. Next, in the present exemplary embodiment, the insulating layer 65 is coated, laid or formed. FIG. 6 illustrates that the insulating layer 65 is coated, laid or formed only at an area in which the driving channel and the sensing channel overlap, as shown in the second exemplary embodiment. However, the insulating layer 65 may alternatively be coated, laid or formed at a touch area or an entire area of the substrate 40, as shown in the foregoing first exemplary embodiment.

When coating, laying or forming of the insulating layer 65 is complete, the second conductive mesh 70 is coated, laid or formed on the insulating layer, and the second conductive mesh 70 is patterned to have (e.g. form) a pattern corresponding to (e.g. forming) the sensing channel 71 and the second wiring 72.

FIG. 7 is a diagram illustrating a process of manufacturing a touch panel according to a fourth exemplary embodiment of the present invention.

Referring to FIG. 7, when an empty space exists between the driving channels 51 and the sensing channels 71, as in the first exemplary embodiment to the third exemplary embodiment, the fourth exemplary embodiment of the present invention solves a visibility problem that the driving channels 51 and the sensing channels 71 are visible to a user. Specifically, when patterning a first conductive mesh 50 in a first pattern, instead of removing an entire conductive mesh 53 of an area other than the driving channel 51, as in the first exemplary embodiment to the third exemplary embodiment of the present invention, as shown in the enlarged view of FIG. 7, only a minimum conductive mesh may be removed so that a conductive mesh constituting the driving channel 51 and the conductive mesh 53 (first auxiliary mesh) not constituting the driving channel 51 are not electrically connected. For example, instead of removing entire conductive meshes (including a plurality of mesh lines) positioned between the driving channels 51, only at least one mesh line adjacent to the driving channel 51 may be removed. Similarly, when patterning a second conductive mesh 70 in a second pattern, a conductive mesh of an area other than the sensing channel 71 may be entirely removed, and as shown in the enlarged view of FIG. 7, only a minimum conductive mesh may be removed so that a conductive mesh constituting the sensing channel 71 and a conductive mesh 73 (second auxiliary mesh) not constituting the sensing channel 71 are not electrically connected.

In FIG. 7, in a plurality of mesh lines included in a conductive mesh not constituting the driving channel 51 and the sensing channel 71, only a mesh line immediately adjacent to the driving channel 51 and the sensing channel 71 may be removed, however the present invention is not limited thereto. For example, in other exemplary embodiments of the present invention, a mesh line may be removed to have a specific pattern. For example, a first mesh line may be removed to 1/3 point from one side end point of the driving channel 51 or the sensing channel 71, a second mesh line may be removed from 1/3 point to 2/3 point, and a first mesh line may be removed from 2/3 point to the other side end point. In this case, the number of the removed mesh lines and a removed pattern form may be variously changed in consideration of touch performance and visibility. Although not shown in FIGs. 4A to 7, a process of manufacturing a touch panel according to the present exemplary embodiment may further include the optional step of printing, coating, laying or forming a protective layer, or stacking a protection substrate on lower layers in order to protect the sensing channel.

Accordingly, as touch panels according to exemplary embodiments of the present invention form driving channels and sensing channels of the touch panel using a conductive mesh, a crossing area of the driving channels and the sensing channels can be reduced. Thereby, according to exemplary embodiments of the present invention, a distance between a driving channel and a sensing channel can be reduced. Accordingly, a thickness of the touch panel can be reduced without deterioration of a touch performance.

Further, exemplary embodiments of the present invention can be applied to methods of manufacturing various types of touch panel. For example, embodiments of the present invention may be applied to a method of stacking a first conductive mesh, insulating layer, and second conductive mesh in a PET film positioned between a display panel and a protection window, a method of stacking a first conductive mesh, insulating layer, and second conductive mesh in a protection window, and a method of stacking a first conductive mesh, insulating layer, and second conductive mesh in a display panel (an upper end portion of a display or a lower end portion of a polarizer) . Further, according to exemplary embodiments of the present invention a sensing channel using a conductive mesh may be formed on one surface of a substrate and a driving channel using a conductive mesh may be formed on another surface (e.g. opposite surface) of a substrate. In this case, a separate insulating layer may be not included. In this case, the substrate may have a thickness of several $\mu$m to hundreds of $\mu$m. Alternatively, after forming driving channels in a first substrate and forming sensing channels in a second substrate, the first substrate and the second substrate may be adhered using a transparent adhesive. In this case, by adhering the first substrate and the second substrate so that the driving channels and the sensing channels are opposite each other, the driving channels and the sensing channels can be protected. In this case, the transparent adhesive may be made of an insulation material. The first substrate, second substrate, and transparent adhesive may have a thickness of several $\mu$m to hundreds $\mu$m.

Further, exemplary embodiments of the present invention may be applied to a protection window in which deco is printed. In particular, exemplary embodiments of the present invention may be applied even to a protection window that prints white deco. Specifically, when using a transparent electrode (ITO), in a method of manufacturing a related-art touch panel, for deposition of ITO, a process is performed at a high temperature, and when deco is printed with a white color, a problem exists in that a color of deco deteriorates. However, according to exemplary embodiments of the present invention, by using a method of coating using a conductive mesh as described above, a process may be performed at a relatively lower temperature. Thereby, exemplary embodiments of the present invention can be applied in a case when manufacturing a touch panel using a protection window in which white deco is printed.

While the present invention has been shown and described with reference to certain exemplary embodiments thereof, it will be understood by those skilled in the art that various changes in form and details may be made therein without departing from the scope of the invention, as defined by the appended claims.

## Claims

1.  A touch panel, comprising:

    a substrate on which a conductive mesh is disposed;
    a plurality of driving channels for recognizing a horizontal axis coordinate, wherein the plurality of driving channels are formed by patterning a first conductive mesh disposed on the substrate;
    a plurality of sensing channels for recognizing a vertical axis coordinate, wherein the plurality of sensing channels are formed by patterning a second conductive mesh disposed on the substrate; and
    an insulating layer positioned between the first conductive mesh and the second conductive mesh.

2.  The touch panel of claim 1, wherein the insulating layer is coated only at an area in which the plurality of driving channels and the plurality of sensing channels overlap or is coated on an entire area of the plurality of driving channels.

3.  The touch panel of claim 1 or 2, further comprising:

    a first auxiliary mesh formed between the plurality of driving channels to be electrically separated from the plurality of driving channels; and
    a second auxiliary mesh formed between the plurality of sensing channels to be electrically separated from the plurality of sensing channels.

4.  The touch panel of claim 1, 2 or 3, further comprising:

    a first wiring connected to the plurality of driving channels and for transmitting a touch signal sensed by each driving channel to a touch processor; and
    a second wiring connected to the plurality of sensing channels and for transmitting a touch signal sensed by each sensing channel to the touch processor.

5.  The touch panel of claim 4, wherein the first wiring and the second wiring have a line width larger than that of a conductive mesh constituting a driving channel and a sensing channel.

6.  The touch panel of any of claims 1 to 5, further comprising a protective layer or a protection substrate for protecting the second channels.

7.  The touch panel of any of claims 1 to 6, wherein the substrate comprises a protection window, display panel, polarizer, and polyethylene terephthalate film.

8.  The touch panel of claim 7, wherein in the protection window, deco is printed.

9.  The touch panel of any of claims 1 to 8, wherein the touch panel is flexible.

10. A method of manufacturing a touch panel, the method comprising the steps of:

    coating a first conductive mesh on a substrate;
    patterning the first conductive mesh to correspond to a plurality of driving channels for recognizing a horizontal axis coordinate;
    coating an insulating layer on a substrate in which the plurality of driving channels are formed;
    coating a second conductive mesh on the substrate in which the insulating layer is coated; and
    patterning the second conductive mesh to correspond to a plurality of sensing channels for recognizing a vertical axis coordinate.

11. The method of claim 10, wherein the step of coating the insulating layer on the substrate on which the plurality of driving channels are formed comprises the step of coating the insulating layer on an entire area on which the plurality of driving channels are positioned or on an area on which the plurality of driving channels and the plurality of sensing channels overlap.

12. The method of claim 10 or 11, wherein the step of patterning the first conductive mesh to correspond to the plurality of driving channels for recognizing the horizontal axis coordinate comprises the step of patterning a first auxiliary mesh formed between the plurality of driving channels to be electrically separated from the plurality of driving channels, and
wherein the step of patterning the second conductive mesh to correspond to the plurality of sensing channels for recognizing the vertical axis coordinate comprises the step of patterning a second auxiliary mesh positioned between the plurality of sensing channels to be electrically separated from the plurality of sensing channels.

13. The method of claim 10, 11 or 12, wherein the step of patterning the first conductive mesh to correspond to the plurality of driving channels for recognizing the horizontal axis coordinate comprises the step of patterning a first wiring connected to the plurality of driving channels for transmitting a touch signal sensed by each driving channel to a touch processor; and
wherein the step of patterning the second conductive mesh to correspond to the plurality of sensing channels for recognizing the vertical axis coordinate comprises the step of patterning a second wiring connected to the plurality of sensing channels for transmitting a touch signal sensed by each sensing channel to the touch processor.

14. The method of any of claims 10 to 13, further comprising at least one of:

   printing or coating a protective layer for protecting the plurality of sensing channels; and
   stacking a protection substrate for protecting the plurality of sensing channels.

15. The method of any of claims 10 to 14, wherein the step of coating the first conductive mesh on the substrate comprises one of:

   coating the first conductive mesh at a protection window;
   coating the first conductive mesh at a display panel;
   coating the first conductive mesh at a polarizer; and
   coating the first conductive mesh at a separate polyethylene terephthalate film.

# FIG. 1
## (RELATED ART)

1mm

4mm

20

10

100

Glass/Plastic

20

OCA

PET Film — 2

OCA

10

PET Film — 1

FIG. 2
(RELATED ART)

FIG. 3

START

COAT FIRST CONDUCTIVE MESH — 301

PATTERN IN FIRST PATTERN — 303

COAT INSULATING LAYER — 305

COAT SECOND CONDUCTIVE MESH — 307

PATTERN IN SECOND PATTERN — 309

END

# FIG. 4A

FIG. 4B

440

Ⓐ

450

460

470

70

60

51

40

71 60

40 51

60 71

40 51

71

60

51

40

FIG. 5A

EP 2 657 818 A2

FIG. 5B

FIG. 6

# FIG. 7

71
73
71
51
53
51